# EUROPEAN PATENT SPECIFICATION

(11) **EP 2 874 482 B1**
(45) Date of publication and mention of the grant of the patent: **27.06.2018**
(21) Application number: 12881020.7
(22) Date of filing: 12.07.2012
(51) Int. Cl.: H02J 50/50, H02J 50/05

(54) **CONTACTLESS ELECTRICAL POWER SUPPLY DEVICE**
KONTAKTLOSE STROMVERSORGUNGSVORRICHTUNG
DISPOSITIF D'ALIMENTATION ÉLECTRIQUE SANS CONTACT

(43) Date of publication of application: 20.05.2015
(73) Proprietor: Fuji Machine Mfg. Co., Ltd., Chiryu-shi Aichi 472-8686 (JP)
(72) Inventor: JINDO Takahiro, Chiryu-shi Aichi 472-8686 (JP); NOMURA Takeshi, Chiryu-shi Aichi 472-8686 (JP); ISHIURA Naomichi, Chiryu-shi Aichi 472-8686 (JP); TAKIKAWA Shinji, Chiryu-shi Aichi 472-8686 (JP)
(74) Representative: Grünecker Patent- und Rechtsanwälte PartG mbB
(86) International application number: PCT/JP2012/067818
(87) International publication number: WO 2014/010057

(56) References cited:
- JP-A- 2004 166 323
- JP-A- 2005 269 857
- JP-A- 2005 269 857
- JP-A- 2006 211 784
- JP-A- 2006 211 803
- JP-A- 2006 211 803
- JP-A- 2006 320 855
- JP-A- 2011 083 132
- JP-A- 2012 110 118

## Description

### Technical Field

The invention relates to a contactless power supply device that supplies electrical power in a contactless manner from a static portion to an electrical load on a movable portion, and more specifically, to a contactless power supply device that can be equipped on apparatuses that make a movable portion movable in a plurality of directions by combining a plurality of drive mechanisms.

### Background Art

As substrate work apparatuses that produce a substrate on which a number of components are mounted, there are a solder printing machine, a component mounting machine, a reflow machine, a substrate inspection machine, and the like. In many cases, a substrate product line is constructed by coupling these machines together in a substrate carrying device. Most of these substrate work apparatuses include a movable portion that moves above a substrate to perform predetermined work, and two sets of drive mechanisms that drive the movable portion in orthogonal biaxial directions, respectively. As the drive mechanisms, linear motor devices or ball screw feed mechanisms are often used. Each linear motor device includes a track member in which an N pole and an S pole of a plurality of magnets are alternately arrayed along a movement direction and a movable portion that is configured so as to include an armature having a core and a coil, and the movable portion moves along the track member by the action of an electromagnetic force. Additionally, in each ball screw feed mechanism, if a ball screw is rotated by a drive motor, a movable portion with a nut to be screwed to a ball screw moves forward and backward.

In the configuration in which the movable portion is provided with the armature of the linear motor device or the drive motor of the ball screw feed mechanism, a deformable power supply cable has been used heretofore in order to supply electrical power to other electrical loads on the driving source and movable portion. However, adverse effects, such as the risk of disconnection caused by an increase in load carrying weight and metal fatigue, are present in the power supply cable, and application of contactless power supply devices has been proposed in recent years in order to solve the adverse effects. Although an electromagnetic induction method using a coil has been often used heretofore as a method for the contactless power supply devices, an electrostatic coupling method in which a capacitor is constituted of electrode plates that face each other has also been used these days. In addition, a magnetic field resonance method or the like has also been studied.

The present applicant discloses a reciprocating device capable of reciprocating a moving body along a track through contactless power supply and capable of being equipped on a substrate work apparatus, in PTL 1. This reciprocating device performs contactless power supply from at least one of a first power transmission portion on one end side of the track and a second power transmission portion on the other end side to a power receiving portion of a moving body. Moreover, an aspect in which a component mounting machine is equipped with the reciprocating device, a slide on which the component mounting head or the head is movably mounted is used as the moving body, and a rail that guides the movement of the component mounting head or the slide is used as the track is disclosed. Accordingly, the power supply cable becomes unnecessary in the component mounting machine, and high-speed movement of the component mounting head or space saving of the component mounting machine can be achieved.

### Citation List

### Patent Literature

PTL 1: JP-A-2012-110118

### Summary of Invention

### Technical Problem

Meanwhile, the component mounting head of the component mounting machine is driven within an X-Y plane above a substrate by respective drive mechanisms orthogonal biaxial directions. That is, in the general configuration of the component mounting machine, a Y-axis moving element is mounted so as to be movable in a Y-axis direction with respect to a machine base, an X-axis moving element is mounted so as to be movable in an X-axis direction with respect to the Y-axis moving element, and the X-axis moving element is provided with the component mounting head. The driving in the X-axis direction and the driving in the Y-axis direction are performed by the separate drive mechanisms, respectively. In the configuration of such a component mounting machine, the related-art contactless power supply device exemplified in PTL 1 has been applied to either power supply from the machine base to the Y-axis moving element or power supply from the Y-axis moving element to the X-axis moving element, and the other power supply has been performed by a cable. That is, contactless power supply from the base via the Y-axis moving element to the X-axis moving element is not performed in the related art.

The invention has been made in view of the above background art, and an object thereof is to provide a contactless power supply device that can perform contactless power supply from a static portion to an electrical load of a movable portion which is driven by combining a plurality of drive mechanisms.

### Solution to Problem

A contactless power supply device according to a first example that does not include all features of the present invention includes a static portion; a first movable portion that is movably mounted on the static portion; a second movable portion that is mounted so as to be movable relative to the first movable portion; a first contactless power supply mechanism that supplies electrical power in a contactless manner from the static portion to a first electrical load on the first movable portion; and a second contactless power supply mechanism that supplies electrical power in a contactless manner from the static portion via the first movable portion to a second electrical load on the second movable portion.

The invention related to Claim 1 is based on the first example, further configured such that the first contactless power supply mechanism includes a first power supply element that is provided at the static portion, and a high-frequency power source circuit that supplies high-frequency electrical power to the first power supply element; and a first power receiving element that is provided at the first movable portion, faces the first power supply element apart therefrom, and receives high-frequency electrical power in a contactless manner, and a first power receiving circuit that converts the high-frequency electrical power received by the first power receiving element, and supplies the converted high-frequency electrical power to the first electrical load, and the second contactless power supply mechanism shares the first power supply element, the high-frequency power source circuit, the first power receiving element, and the first power receiving circuit of the first contactless power supply mechanism, and includes a second power supply element that is provided at the first movable portion, and a high-frequency power transmitting circuit that has electrical power supplied from the first power receiving circuit and that supplies high-frequency electrical power to the second power supply element; and a second power receiving element that is provided at the second movable portion, faces the second power supply element apart therefrom, and receives high-frequency electrical power in a contactless manner, and a second power receiving circuit that converts the high-frequency electrical power received by the second power receiving element, and supplies the converted high-frequency electrical power to the second electrical load.

In a related example not claimed but useful for understanding the present invention, a contactless power supply device according to the first example is further configured such that the first contactless power supply mechanism includes a first power supply element that is provided at the static portion, and a high-frequency power source circuit that supplies high-frequency electrical power to the first power supply element; and a first power receiving element that is provided at the first movable portion, faces the first power supply element apart therefrom, and receives high-frequency electrical power in a contactless manner, and a first power receiving circuit that converts the high-frequency electrical power received by the first power receiving element, and supplies the converted high-frequency electrical power to the first electrical load, and the second contactless power supply mechanism shares the first power supply element and the high-frequency power source circuit of the first contactless power supply mechanism, and includes a relay power receiving element that is provided at the first movable portion, is disposed next to the first power receiving element, faces the first power supply element apart therefrom, and receives high-frequency electrical power in a contactless manner; and a relay power supply element that is electrically connected to the relay power receiving element, a second power receiving element that is provided at the second movable portion, faces the relay power supply element apart therefrom, and receives high-frequency electrical power in a contactless manner, and a second power receiving circuit that converts the high-frequency electrical power received by the second power receiving element, and supplies the converted high-frequency electrical power to the second electrical load.

The invention related to Claim 2 is based on the first example, further configured such that the first contactless power supply mechanism includes a first power supply element that is provided at the static portion, and a first high-frequency power source circuit that supplies high-frequency electrical power to the first power supply element; and a first power receiving element that is provided at the first movable portion, faces the first power supply element apart therefrom, and receives high-frequency electrical power in a contactless manner, and a first power receiving circuit that converts the high-frequency electrical power received by the first power receiving element, and supplies the converted high-frequency electrical power to the first electrical load, and the second contactless power supply mechanism includes a third power supply element that is provided at the static portion, and a second high-frequency power source circuit that supplies high-frequency electrical power to the third power supply element; a relay power receiving element that is provided at the first movable portion, faces the third power supply element apart therefrom, and receives high-frequency electrical power in a contactless manner; and a relay power supply element that is electrically connected to the relay power receiving element; and a second power receiving element that is provided at the second movable portion, faces the relay power supply element apart therefrom, and receives high-frequency electrical power in a contactless manner, and a second power receiving circuit that converts the high-frequency electrical power received by the second power receiving element, and supplies the converted high-frequency electrical power to the second electrical load.

In the invention related to Claim 3 based on either of Claims 1 or 2, at least one circuit among the high-frequency power source circuit, the high-frequency power transmitting circuit, and the second high-frequency power source circuit variably adjusts the frequency of the high-frequency power to perform contactless power supply using a resonant circuit.

In the invention related to Claim 4 based on any one of Claims 1 to 3, the first power supply element, the first power receiving element, the second power supply element, the second power receiving element, the relay power receiving element, the relay power supply element, and the third power supply element are electrode plates, respectively.

In the invention related to Claim 5 based on any one of Claims 1 to 4, the first movable portion is a Y-axis moving element that is equipped on a component mounting machine that mounts components on a substrate, and is movable in a Y-axis direction perpendicular to an X-axis direction in which the substrate is carried in and carried out, and the second movable portion is an X-axis moving element having a component mounting head that performs a component mounting operation and being movable relative to the X-axis direction.

### Advantageous Effects of Invention

In the contactless power supply device of the first example, not only can contactless power supply be performed from the static portion to the first electrical load on the first movable portion by the first contactless power supply mechanism, but also contactless power supply can be performed from the static portion via the first movable portion to the second electrical load on the second movable portion by the second contactless power supply mechanism. Accordingly, contactless power supply can be performed from the static portion to the second electrical load of the second movable portion which is driven by combining a plurality of drive mechanisms. Accordingly, the related-art deformable power supply cables becomes completely unnecessary. As a result, adverse effects, the risk of disconnection caused by an increase in the load carrying weight of the cables and metal fatigue, can be completely eliminated.

In the invention related to Claim 1, the first power receiving element and the first power receiving circuit of the first movable portion supply electrical power enough for both of the first electrical load and the second electrical load. Additionally, the high-frequency power transmitting circuit that has electrical power supplied thereto from the first power receiving circuit on the first movable portion supplies electrical power enough for the second electrical load of the second movable portion, and the output frequency of the electrical power can be adjusted separately from the high-frequency power source circuit of the static portion. Accordingly, contactless power supply can be performed from the static portion to the second electrical load of the second movable portion which is driven by combining a plurality of drive mechanisms. Additionally, since separate frequencies can be used for the contactless power supply from the static portion to the first movable portion and the contactless power supply from the first movable portion to the second movable portion, adjustment of the frequencies is relatively easy.

In the contactless power supply device of the related example which is not claimed, the first power receiving element and the first power receiving circuit of the first movable portion supply electrical power enough for the first electrical load. Additionally, the relay power receiving element and the relay power supply element of the first movable portion relay-supply electrical power enough for the second electrical load of the second movable portion. Accordingly, contactless power supply can be performed from the static portion to the second electrical load of the second movable portion which is by combining a plurality of drive mechanisms. Additionally, as compared to the configuration of Claim 2, the relay power receiving element and the relay power supply element increase. However, since the high-frequency power transmitting circuit becomes unnecessary and the power supply capacity of the first power receiving circuit can also be made small, the weight of the first movable portion can be reduced by an amount equivalent to the difference, and device costs can be reduced.

In the invention related to Claim 2, the first power receiving element and the first power receiving circuit of the first movable portion supply electrical power enough for the first electrical load. Additionally, the relay power receiving element and the relay power supply element of the first movable portion relay-supply electrical power enough for the second electrical load of the second movable portion. The high-frequency power source circuit and the second high-frequency power source circuit of the static portion can independently and separately adjust output frequencies. Accordingly, contactless power supply can be performed from the static portion to the second electrical load of the second movable portion which is driven by combining a plurality of drive mechanisms. Additionally, similar to Claim 2, since separate frequencies can be used for the contactless power supply from the static portion to the first movable portion and the contactless power supply from the static portion to the second movable portion, adjustment of the frequencies is relatively easy.

In the invention related to Claim 3, at least one circuit of the high-frequency power source circuit, the high-frequency power transmitting circuit, and the second high-frequency power source circuit variably adjusts the frequency of the high-frequency electrical power to perform contactless power supply using a resonant circuit. Accordingly, a resonant current can be sent to ensure large power supply capacity and high power supply efficiency.

In the invention related to Claim 4, the electrode plates are used as the first power supply element, the first power receiving element, the second power supply element, the second power receiving element, the relay power receiving element, the relay power supply element, and the third power supply element, respectively. Thus, contactless power supply to the first electrical load of the first movable portion and the second electrical load of the second movable portion can be performed by an electrostatic coupling method. Accordingly, even if a linear motor device is used for a drive mechanism of the first movable portion and the second movable portion, it is not needed to consider mutual electrostatic interference and mutual magnetic interference, and there is a lot of flexibility in arranging constituent members. Additionally, since the electrode plates are more light-weight than the electromagnetic induction type power supply coil and power receiving coil, the weight of the first movable portion and the second movable portion can be reduced.

In the invention related to Claim 5, the first movable portion is the Y-axis moving element of the component mounting machine, and the second movable portion is the X-axis moving element having the component mounting head. The contactless power supply device of the invention can be equipped on the component mounting machine, and the cables that supplies electrical power from the static portion to the component mounting head becomes completely unnecessary. As a result, the load carrying weight of the cable is eliminated, the component mounting head can be driven at a higher speed than in the related art, and the risk of cable disconnection can be eliminated.

### Brief Description of Drawings

[Fig. 1] Fig. 1 is a perspective view illustrating an overall configuration of a component mounting machine to which a contactless power supply device of a first embodiment of the invention can be applied.
[Fig. 2] Fig. 2 is a perspective view illustrating main portions of the contactless power supply device of the first embodiment of the invention.
[Fig. 3] Fig. 3 is a perspective view of a Y-axis moving element of the contactless power supply device of the first embodiment.
[Fig. 4] Fig. 4 is a perspective view of the Y-axis moving element viewed from an oblique lower side.
[Fig. 5] Fig. 5 is a view illustrating the main portions of the contactless power supply device of the first embodiment when viewed in a Y-axis direction.
[Fig. 6] Fig. 6 is an electric circuit diagram of the contactless power supply device of the first embodiment.
[Fig. 7] Fig. 7 is a perspective view illustrating main portions of a contactless power supply device of a related example which is not claimed but useful for understanding the present invention.
[Fig. 8] Fig. 8 is a perspective view of the Y-axis moving element of the contactless power supply device of the related example.
[Fig. 9] Fig. 9 is a perspective view of the Y-axis moving element when viewed from an oblique lower side.
[Fig. 10] Fig. 10 is a view illustrating the main portions of the contactless power supply device of the related example when viewed in a Y-axis direction.
[Fig. 11] Fig. 11 is an electric circuit diagram of the contactless power supply device of the related example.
[Fig. 12] Fig. 12 is an electric circuit diagram of a contactless power supply device of a second embodiment.

### Description of Embodiments

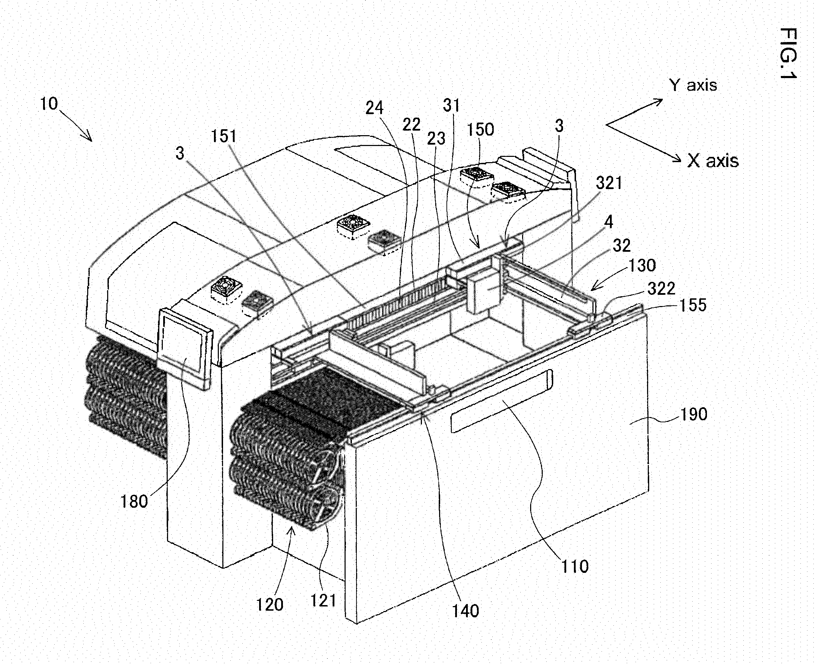

First, a component mounting machine 10 to which the invention can be applied will be described. Fig. 1 is a perspective view illustrating an overall configuration of the component mounting machine 10 to which a contactless power supply device 1 of the first embodiment of the invention can be applied. The component mounting machine 10 is a device that mounts a number of components on a substrate, and is configured such that two component mounting units with the same structure are substantially symmetrically arranged. Here, a component mounting unit in a state where a cover on a right near side of Fig. 1 is detached will be described as an example. In addition, a width direction of the component mounting machine 10 that turns from a left far side to the right near side in the drawing is an X-axis direction in which a substrate is carried out and carried in, and a longitudinal direction of the component mounting machine 10 that turns from a left near side to a right far side in the drawing is a Y-axis direction.

The component mounting machine 10 is configured such that a substrate carrying device 110, a component supply device 120, two component transfer devices 130 and 140, and the like are assembled to a machine base 190. The substrate carrying device 110 is disposed so as to cross the vicinity of the center of the component mounting machine 10 in the longitudinal direction in an X-axis direction. The substrate carrying device 110 has a carrying conveyor (not illustrated), and carries a substrate in the X-axis direction. Additionally, the substrate carrying device 110 has a clamp device (not illustrated), and fixes and holds a substrate to a predetermined mounting work position. The component supply device 120 is provided at a front portion (front left side of Fig. 1) and a rear portion (not seen in the drawing) of the component mounting machine 10 in the longitudinal direction. The component supply device 120 has a plurality of cassette type feeders 121, and continuously supplies components from carrier tapes set in the respective feeders 121 to the two component transfer devices 130 and 140.

The two component transfer devices 130 and 140 are so-called XY robot type devices that are movable in the X-axis direction and in the Y-axis direction. The two component transfer devices 130 and 140 are disposed on a front side and a rear side of the component mounting machine 10 in the longitudinal direction, respectively, so as to face each other. Each of the component transfer devices 130 and 140 has a linear motor device 150 for movement in the Y-axis direction.

The linear motor device 150 is constituted of a track member 151 and an auxiliary rail 155 that are common to the two component transfer devices 130 and 140, and Y-axis moving elements 3 provided for the two component transfer devices 130 and 140, respectively. The track member 151 is equivalent to a portion of a static portion 2 of the invention, has a groove shape that opens upward, and extends in the Y-axis direction. Each Y-axis moving element 3 is equivalent to a first movable portion of the invention, and is constituted of a movable body portion 31, a sliding member 32, and the like. The movable body portion 31 extends in the Y-axis direction, and is mounted on an upper edge of the track member 151 so as to be movable in the Y-axis direction. The sliding member 32 extends in the X-axis direction from the movable body portion 31. The sliding member 32 has one end 321 coupled to the movable body portion 31 and has the other end 322 movably mounted on the auxiliary rail 155, and is adapted to move in the Y-axis direction integrally with the movable body portion 31. The component mounting head 4 is mounted on the sliding member 32, and is adapted to move in the X-axis direction. The component mounting head 4 is equivalent to a second movable portion of the invention.

The component mounting machine 10 further includes a display setting device 180 for exchanging information with an operator, a camera (not illustrated) that images a substrate and components, or the like.

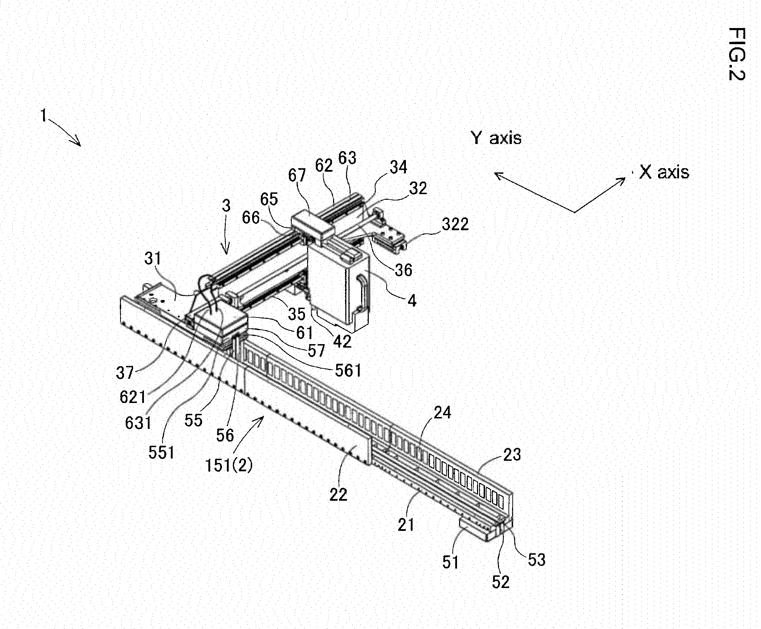

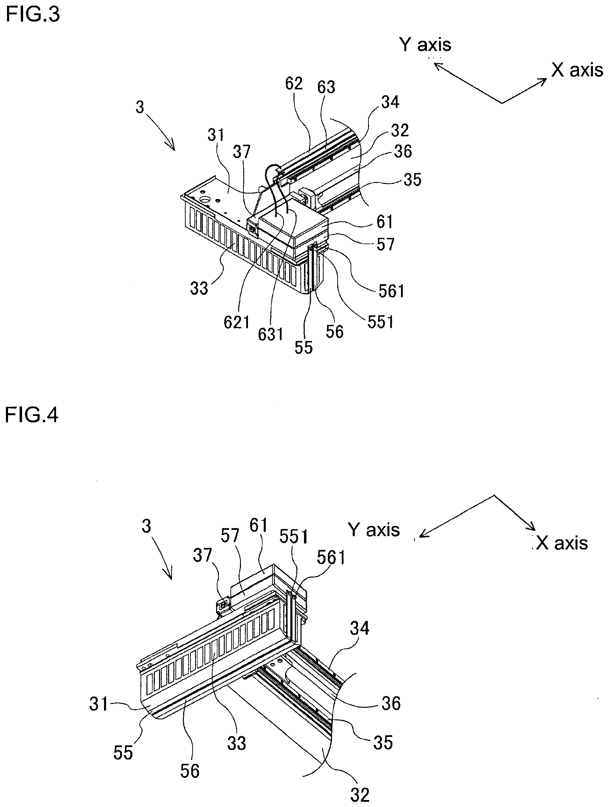

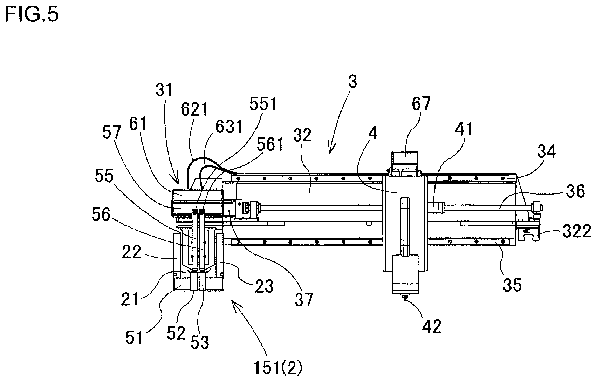

Next, an aspect to which the contactless power supply device 1 of the first embodiment of the invention is applied to the component mounting machine 10 will be described, referring to Figs. 2 to 6. Fig. 2 is a perspective view illustrating main portions of the contactless power supply device 1 of the first embodiment of the invention. Fig. 3 is a perspective view of a Y-axis moving element 3 of the contactless power supply device 1 of the first embodiment, and Fig. 4 is a perspective view of the Y-axis moving element 3 when viewed from an oblique lower side. Additionally, Fig. 5 is a view of the main portions of the contactless power supply device 1 of the first embodiment when viewed in the Y-axis direction.

The track member 151, as illustrated in Figs. 2 and 5, is formed by a bottom wall member 21 and two side wall members 22 and 23 erected from both side edges of the bottom wall member 21, and has a groove shape that opens upward. A plurality of magnets 24 are provided in a line along the Y-axis direction on the inner surfaces of the side wall members 22 and 23, respectively, which face each other. In addition, a portion of the side wall member 22 on the near side is omitted in Fig. 3.

A pair of first power supply electrode plates 52 and 53 are disposed on an upper surface of the bottom wall member 21. The first power supply electrode plates 52 and 53 are equivalent to a first power supply element of the invention. The first power supply electrode plates 52 and 53 are formed in a belt shape using a metal plate or the like, and extend parallel to the Y-axis direction while being spaced apart from each other. A high-frequency power source circuit 51 is provided on a lower surface of one end portion (right near side of Fig. 2) of the bottom wall member 21. One end portion (right near side of Fig. 2) of each of the pair of first power supply electrode plates 52 and 53 is bent downward on one end surface of the bottom wall member 21, and is electrically connected to an output terminal of the high-frequency power source circuit 51. The high-frequency power source circuit 51 supplies a high-frequency electrical power of, for example, a 100 kHz to 100 MHz band. The output frequency and the output voltage of the high-frequency power source circuit 51 are made adjustable, and a sinusoidal wave, a rectangular wave, or the like can be exemplified as an output voltage waveform. A specific circuit configuration of the high-frequency power source circuit 51 will be described below.

The movable body portion 31 of the Y-axis moving element 3 extends in the Y-axis direction, and has a lower portion fitted into the groove shape of the track member 151. The movable body portion 31 is mounted on an upper edge of the side wall member 23 on a side near the auxiliary rail 155, and is made movable in the Y-axis direction. An armature 33 that faces the magnets 24 of the track member 151 and generates a propulsive force is disposed on both side surfaces of the movable body portion 31 (refer to Figs. 3 and 4) . The armature 33 is formed of a coil to which an electric current is applied, and a core that is magnetized by an electric current that flows through the coil. The magnitude and the electric-current application time zone of the electric current that flows through the coil are controlled by a control unit (not illustrated) that is provided on the movable body portion 31.

Additionally, as illustrated in Fig. 4, a pair of first power receiving electrode plates 55 and 56 are disposed on the bottom surface of the movable body portion 31. The first power receiving electrode plates 55 and 56 are equivalent to a first power receiving element of the invention. The first power receiving electrode plates 55 and 56 are formed in a belt shape with a length approximately equal to the Y-axis direction length of the movable body portion 31, using a metal plate or the like, and extend parallel to the Y-axis direction while being spaced apart from each other. The pair of first power receiving electrode plates 55 and 56 face the first power supply electrode plates 52 and 53 of the bottom wall member 21 apart therefrom, and constitute a pair of capacitors. Even if the Y-axis moving element 3 moves in the Y-axis direction, the electrostatic capacity of the capacitors is kept substantially constant. The first power receiving electrode plates 55 and 56 are bent on one end surface (end surface on the right near side of Fig. 3) of the movable body portion 31, and extend upward. Upper end portions 551 and 561 of the bent tips of the first power receiving electrode plates 55 and 56 are electrically connected to input terminals of a first power receiving circuit 57 disposed on an upper side of the movable body portion 31.

The first power receiving circuit 57 is a circuit that converts the high-frequency electrical power received by the first power receiving electrode plates 55 and 56, and supplies the converted high-frequency electrical power to a first electrical load L1 (will be described below in detail) and a first high-frequency power transmitting circuit 61. The high-frequency power transmitting circuit 61 is disposed on an upper side of the first power receiving circuit 57. The high-frequency power transmitting circuit 61 has an input terminal electrically connected to an output terminal of the first power receiving circuit 57, and has electrical power supplied from the first power receiving circuit 57. The high-frequency power transmitting circuit 61 has output terminals electrically connected to the second power supply electrode plates 62 and 63 to be described below, and supplies high-frequency electrical power thereto. Specific circuit configurations of the first power receiving circuit 57 and the high-frequency power transmitting circuit 61 will be described below.

The sliding member 32 of the Y-axis moving element 3 extends in the X-axis direction from the movable body portion 31. X-axis rails 34 and 35 extending in the X-axis direction are disposed at an upper portion and a lower portion of the sliding member 32 on one lateral surface side. Additionally, a ball screw 36 that constitutes a ball screw feed mechanism is rotatably born at a substantially middle height on one lateral surface side of the sliding member 32. The ball screw 36 is rotationally driven by a drive motor 37 that is disposed next to the first power receiving circuit 57 of the movable body portion 31. The rotating speed and the rotational direction of the drive motor 37 are variably controlled by the control from the control unit (not illustrated) that is provided on the movable body portion 31.

The armature 33 of the linear motor device 150, the drive motor 37 of the ball screw feed mechanism, the control unit (not illustrated), and sensors of which the description is omitted are provided as electrical components in the Y-axis moving element 3. These electrical components are equivalent to the first electrical load L1 on the first movable portion of the invention, and a direct-current load is used in the first embodiment.

The pair of second power supply electrode plates 62 and 63 are disposed on the upper surface of the sliding member 32. The second power supply electrode plates 62 and 63 are equivalent to a second power supply element of the invention. The second power supply electrode plates 62 and 63 are formed in a belt shape using a metal plate or the like, and extend parallel to the X-axis direction while being spaced apart from each other. The pair of second power supply electrode plates 62 and 63 are electrically connected to the output terminals of the high-frequency power transmitting circuit 61 of the movable body portion 31, using power supply lines 621 and 631.

The component mounting head 4 is mounted on the upper and lower X-axis rails 34 and 35 of the sliding member 32, and is made movable in the X-axis direction. As illustrated in Fig. 5, the component mounting head 4 has a nut drive unit 41 that is screwed to a ball screw 36 of the sliding member 32. Accordingly, if the drive motor 37 rotationally drives the ball screw 36, the nut drive unit 41 threadedly advances or threadedly retreats, and the entire component mounting head 4 moves in the X-axis direction. A nozzle holder and a suction nozzle 42 are provided at a lower end of the component mounting head 4. The suction nozzle 42 is elevatable and rotatable, suctions and picks up a component from the component supply device 120, using negative pressure, and mounts the component on a substrate at a mounting work position.

A motor for elevating and rotating the suction nozzle 42, an air pump or valves for generating the negative pressure, a control unit for controlling the operation of the suction nozzle 41, and sensors of which the description is omitted are provided as electrical components in the component mounting head 4. These electrical components are equivalent to a second electrical load L2 on the second movable portion of the invention, and a direct-current load is used in the first embodiment.

A second power receiving circuit 67 is disposed at an upper portion of the component mounting head 4 so that the second power receiving circuit 67 overhangs the second power supply electrode plates 63 and 64 of the sliding member 32. A pair of second power receiving electrode plates 65 and 66 are disposed on a bottom surface of the second power receiving circuit 67 on a tip side (refer to Fig. 2). The second power receiving electrode plates 65 and 66 are equivalent to a second power receiving element of the invention. The second power receiving electrode plates 65 and 66 are formed using a metal plate or the like and are arranged so as to be spaced apart from each other. The pair of second power receiving electrode plates 65 and 66 face the second power supply electrode plates 62 and 63 apart therefrom, and constitute a pair of capacitors. Even if the component mounting head 4 moves in the X-axis direction, the electrostatic capacity of the capacitors is kept substantially constant. The second power receiving electrode plates 65 and 66 are electrically connected to input terminals of the second power receiving circuit 67. The second power receiving circuit 67 converts the high-frequency electrical power received by the second power receiving electrode plates 65 and 66, and supplies the converted high-frequency electrical power to the second electrical load L2. A specific circuit configuration of the second power receiving circuit 67 will be described below. In addition, a combination of the component mounting head 4 and the second power receiving circuit 67 is equivalent to an X-axis moving element.

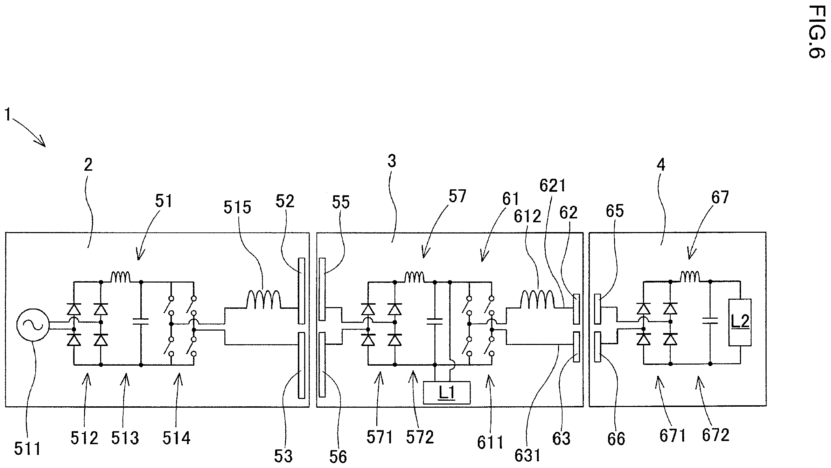

Next, an electric circuit configuration of the contactless power supply device 1 of the first embodiment will be described. Fig. 6 is an electric circuit diagram of the contactless power supply device 1 of the first embodiment. First, the arrangement of the respective constituent members will be described again, for the purpose of confirmation. The high-frequency power source circuit 51 and the pair of first power supply electrode plates 52 and 53 are disposed at the static portion 2 constituted of the track member 151 and the like. The pair of first power receiving electrode plates 55 and 56, the first power receiving circuit 57, the high-frequency power transmitting circuit 61, the second power supply electrode plates 62 and 63, and the first electrical load L1 are disposed in the Y-axis moving element 3 equivalent to the first movable portion. The second power receiving electrode plates 65 and 66, the second power receiving circuit 67, and the second electrical load L2 are disposed at the component mounting head 4 equivalent to the second movable portion.

The high-frequency power source circuit 51 of the static portion 2 is constituted of a commercial frequency power source 511, a full wave rectifying circuit 512, a smoothing circuit 513 , a high-frequency generating circuit 514 , and a tuning coil 515. The full wave rectifying circuit 51 is configured by the bridge connection of four rectifier diodes, and performs full wave rectification of AC power of the commercial frequency power source 511 to output DC power including a pulsating current component. The smoothing circuit 513 smoothens the pulsating current component, and outputs DC power with little fluctuation.

The high-frequency generating circuit 514 is constituted by the bridge connection of four switching elements, and converts DC power into high-frequency electrical power. The switching timing of the high-frequency generating circuit 514 is controlled by a high-frequency control unit (not illustrated), and the output frequency of the high-frequency generating circuit is variably adjusted. One of output terminals of the high-frequency generating circuit 514 is electrically connected to one first power supply electrode plate 52 via the tuning coil 515. The other of the output terminals is directly and electrically connected to the other first power supply electrode plate 53.

The first power receiving circuit 57 of the Y-axis moving element 3 is constituted of a full wave rectifying circuit 571 and a smoothing circuit 572. The full wave rectifying circuit 571 is constituted by the bridge connection of four rectifier diodes, and has an input side electrically connected to the pair of first power receiving electrode plates 55 and 56. The full wave rectifying circuit 571 performs full wave rectification of the high-frequency electrical power received by the first power receiving electrode plates 55 and 56, and outputs DC power including a pulsating current component. The smoothing circuit 572 smoothens the pulsating current component, outputs DC power with little fluctuation, and supplies the output DC power to the first electrical load L1 and the high-frequency power transmitting circuit 61.

The high-frequency power transmitting circuit 61 is constituted of a high-frequency generating circuit 611 that bridge-connects four switching elements and a tuning coil 612. The high-frequency generating circuit 611 has an input side electrically connected to the smoothing circuit 572 so as to supply DC power thereto, and converts the DC power into high-frequency electrical power. The switching timing of the high-frequency generating circuit 611 is controlled by a high-frequency control unit (not illustrated), and the output frequency of the high-frequency generating circuit is variably adjusted. One of output terminals of the high-frequency generating circuit 611 is electrically connected to one second power supply electrode plate 62 via the tuning coil 612. The other of the output terminals is directly and electrically connected to the other second power supply electrode plate 63.

The second power receiving circuit 67 of the component mounting head 4 is constituted of a full wave rectifying circuit 671 and a smoothing circuit 672. The full wave rectifying circuit 671 is constituted by the bridge connection of four rectifier diodes, and has an input side electrically connected to the pair of second power receiving electrode plates 65 and 66. The full wave rectifying circuit 671 performs full wave rectification of the high-frequency electrical power received by the second power receiving electrode plates 65 and 66, and outputs DC power including a pulsating current component. The smoothing circuit 672 smoothens the pulsating current component, outputs DC power with little fluctuation, and supplies the output DC power to the second electrical load L2.

In the first embodiment, a first contactless power supply mechanism of the invention is configured so as to have the high-frequency power source circuit 51, the pair of first power supply electrode plates 52 and 53, the pair of first power receiving electrode plates 55 and 56, and the first power receiving circuit 57. Here, the tuning coil 515 is properly selected and the output frequency of the high-frequency generating circuit 514 is variably adjusted so that contactless power supply using a resonant circuit can be performed. Accordingly, a resonant current flows between the high-frequency power source circuit 51 and the first power receiving circuit 57, and large power supply capacity and high power supply efficiency can be ensured.

Additionally, a second contactless power supply mechanism is configured so as to share the high-frequency power source circuit 51, the pair of first power supply electrode plates 52 and 53, the pair of first power receiving electrode plates 55 and 56, and the first power receiving circuit 57, and have the high-frequency power transmitting circuit 61, the pair of second power supply electrode plates 62 and 63, the pair of second power receiving electrode plates 65 and 66, and the second power receiving circuit 67. Here, the tuning coil 612 is properly selected and the output frequency of the high-frequency generating circuit 611 is variably adjusted so that contactless power supply using a resonant circuit from the Y-axis moving element 3 to the component mounting head 4 can be performed. Accordingly, a resonant current flows between the high-frequency power transmitting circuit 61 and the second power receiving circuit 67, and large power supply capacity and high power supply efficiency can be ensured.

As described above, according to the contactless power supply device 1 of the first embodiment, contactless power supply from the static portion 2 to the first electrical load L1 of the Y-axis moving element 3 can be performed. In addition, the contactless power supply from the static portion 2 to the second electrical load L2 of the component mounting head 4 driven by combining the linear motor device 150 and the ball screw feed mechanism can also be performed. In contrast, in the related art, only one of power supply from the static portion 2 to the Y-axis moving element 3 and power supply from the Y-axis moving element 3 to the component mounting head 4 is made contactless. Accordingly, in the first embodiment, a cable that supplies electrical power from the static portion 2 to the component mounting head 4 is completely unnecessary, the load carrying weight of the cables becomes zero, the component mounting head 4 can be driven at a higher speed than in the related art, and the risk of cable disconnection can be eliminated. Additionally, since separate frequencies can be used for the contactless power supply from the static portion 2 to the Y-axis moving element 3 and the contactless power supply from the Y-axis moving element 3 to the component mounting head 4, adjustment of the frequencies is relatively easy.

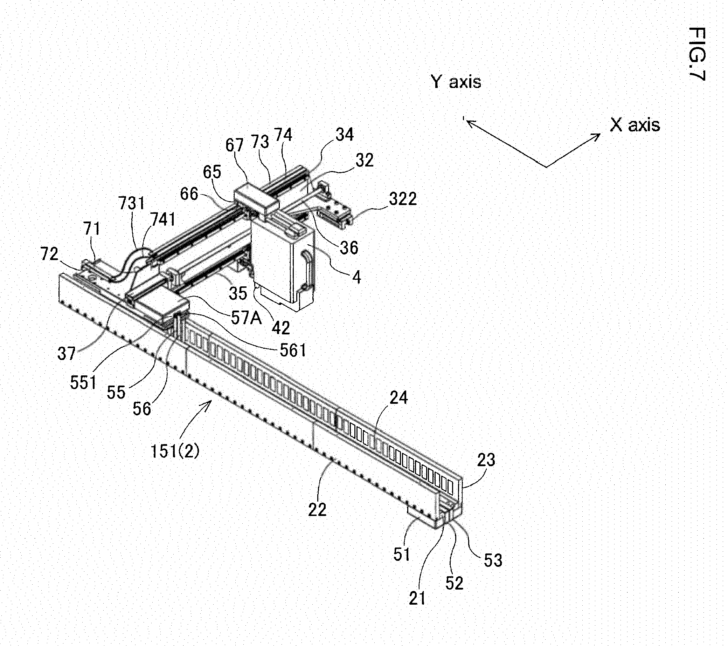

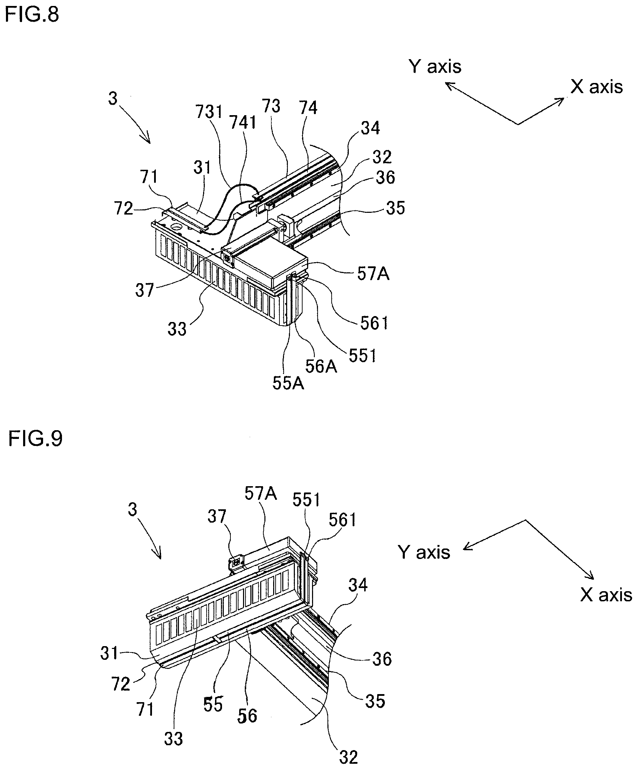

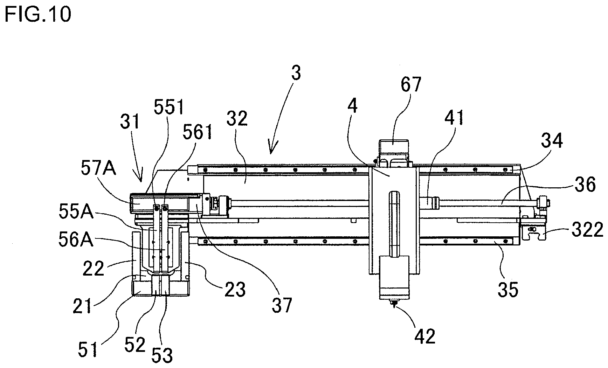

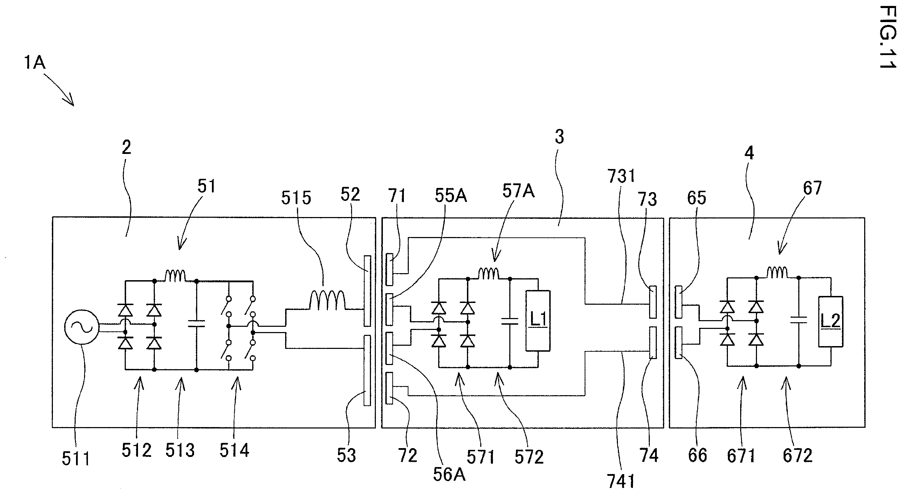

Next, a contactless power supply device 1A of a related example which is not claimed but useful for understanding the present invention will be described with reference to Figs. 7 to 11. Fig. 7 is a perspective view illustrating main portions of the contactless power supply device 1A of the related example. Fig. 8 is a perspective view of the Y-axis moving element 3 of the contactless power supply device 1A of the related example, and Fig. 9 is a perspective view of the Y-axis moving element 3 when viewed from an oblique lower side. Additionally, Fig. 10 is a view of the main portions of the contactless power supply device 1A of the related example when viewed in the Y-axis direction. Moreover, Fig. 11 is an electric circuit diagram of the contactless power supply device 1A of the related example. In Figs. 7 to 11, members having the same structures or the same functions as those of the first embodiment will be designated by the same reference numerals, and the description thereof will be omitted. The contactless power supply device 1A of the related example, similar to the first embodiment, can be equipped on the component mounting machine 10. In the related example, the basic structure of the track member 151, the Y-axis moving element 3, and the component mounting head 4 on the static portion 2 side, is not different from that of the first embodiment, and is different therefrom in terms of the aspect of the first and second contactless power supply mechanisms.

In the related example, the aspect of the first power supply electrode plates 52 and 53 and the high-frequency power source circuit 51 that are provided at the track member 151 are the same as those of the first embodiment.

As illustrated in Fig. 9, a pair of first power receiving electrode plates 55A and 56A and a pair of relay power receiving electrode plates 71 and 72 are disposed to line up in the Y-axis direction on the bottom surface of the movable body portion 31 of the Y-axis moving element 3. The first power receiving electrode plates 55A and 56A are equivalent to a first power receiving element. The first power receiving electrode plates 55A and 56A are formed in a belt shape with a length of about 60% of the Y-axis direction length of the movable body portion 31, using a metal plate or the like, and extend parallel to the Y-axis direction while being spaced apart from each other. The pair of first power receiving electrode plates 55A and 56A face the first power supply electrode plates 52 and 53 of the bottom wall member 21 apart therefrom, and constitute a pair of capacitors. Even if the Y-axis moving element 3 moves in the Y-axis direction, the electrostatic capacity of the capacitors is kept substantially constant.

The first power receiving electrode plates 55A and 56A are bent on one end surface (end surface on the right near side of Fig. 8) of the movable body portion 31, and extend upward. The upper end portions 551 and 561 of the bent tips of the first power receiving electrode plates 55A and 56A are electrically connected to input terminals of a first power receiving circuit 57A disposed on an upper side of the movable body portion 31. The first power receiving circuit 57A is a circuit that converts the high-frequency electrical power received by the first power receiving electrode plates 55A and 56A, and supplies the converted high-frequency electrical power to the first electrical load L1. In the related example, the high-frequency power transmitting circuit 61 is unnecessary.

The relay power receiving electrode plates 71 and 72 are equivalent to a relay power receiving element. The relay power receiving electrode plates 71 and 72 are formed in a belt shape with a length shorter than that of the first power receiving electrode plates 55A and 56A, using a metal plate or the like, and extend parallel to the Y-axis direction while being spaced apart from each other. The pair of relay power receiving electrode plates 71 and 72 face the first power supply electrode plates 52 and 53 of the bottom wall member 21 apart therefrom, and constitute a pair of capacitors. Even if the Y-axis moving element 3 moves in the Y-axis direction, the electrostatic capacity of the capacitors is kept substantially constant. The relay power receiving electrode plates 71 and 72 are bent and extend upward on a lower side of the other end surface (end surface on the left far side of Fig. 8) of the movable body portion 31, and are also bent and extend up to the upper surface of the movable body portion 31, on an upper side of the other end surface.

The structure of the sliding member 32 of the Y-axis moving element 3 is the same as that of the first embodiment, and the first electrical load L1 on the Y-axis moving element 3 is the same as that of the first embodiment. A pair of relay power supply electrode plates 73 and 74 disposed on the upper surface of the sliding member 32 have the same shapes as the second power supply electrode plates 62 and 63 of the first embodiment. The pair of relay power supply electrode plates 73 and 74 are electrically connected to the relay power receiving electrode plates 71 and 72, using junction lines 731 and 741.

The structure of the component mounting head 4 is the same as that of the first embodiment, and the pair of second power receiving electrode plates 65 and 66 face the relay power supply electrode plates 73 and 74 apart therefrom, and constitute a pair of capacitors. Additionally, the second electrical load L2 is the same as that of the first embodiment.

Next, an electric circuit configuration of the contactless power supply device 1 of the related example will be described with referee to Fig. 11. First, the arrangement of the respective constituent members will be described again, for the purpose of confirmation. The high-frequency power source circuit 51 and the pair of first power supply electrode plates 52 and 53 are disposed at the static portion 2 constituted of the track member 151 and the like. The pair of first power receiving electrode plates 55A and 56A, the first power receiving circuit 57A, the pair of relay power receiving electrode plates 71 and 72, the pair of relay power supply electrode plates 73 and 74, and the first electrical load L1 are disposed in the Y-axis moving element 3 equivalent to the first movable portion. The second power receiving electrode plates 65 and 66, the second power receiving circuit 67, and the second electrical load L2 are disposed at the component mounting head 4 equivalent to the second movable portion.

In the related example, a power supply route to the first electrical load L1 of the first contactless power supply mechanism is not different from that of the first embodiment. Meanwhile, a power supply route to the second electrical load L2 of the second contactless power supply mechanism branches from the relay power receiving electrode plates 71 and 72. Although the power supply route to the second electrical load L2 goes via four capacitors constituted of a total of four sets of electrode plates (52 and 71, 53 and 72, 73 and 65, and 74 and 66), there is no change in that contactless power supply can be made through the electrostatic coupling method.

According to the contactless power supply device 1A of the related example, contactless power supply from the static portion 2 to the second electrical load L2 of the component mounting head 4 driven by combining the linear motor device 150 and the ball screw feed mechanism can be performed. Accordingly, a cable that supplies electrical power from the static portion 2 to the component mounting head 4 is completely unnecessary, the load carrying weight of the cable becomes zero, the component mounting head 4 can be driven at higher speed than in the related art, and the risk of cable disconnection can be eliminated. Additionally, as compared to the configuration of the first embodiment, the relay power receiving electrode plates 71 and 72 and the relay power supply electrode plates 73 and 74 increase. However, since the high-frequency power transmitting circuit 61 becomes unnecessary and the power supply capacity of the first power receiving circuit 57A can also be made small, the weight of the Y-axis moving element 3 can be reduced by an amount equivalent to the difference, and device costs can be reduced.

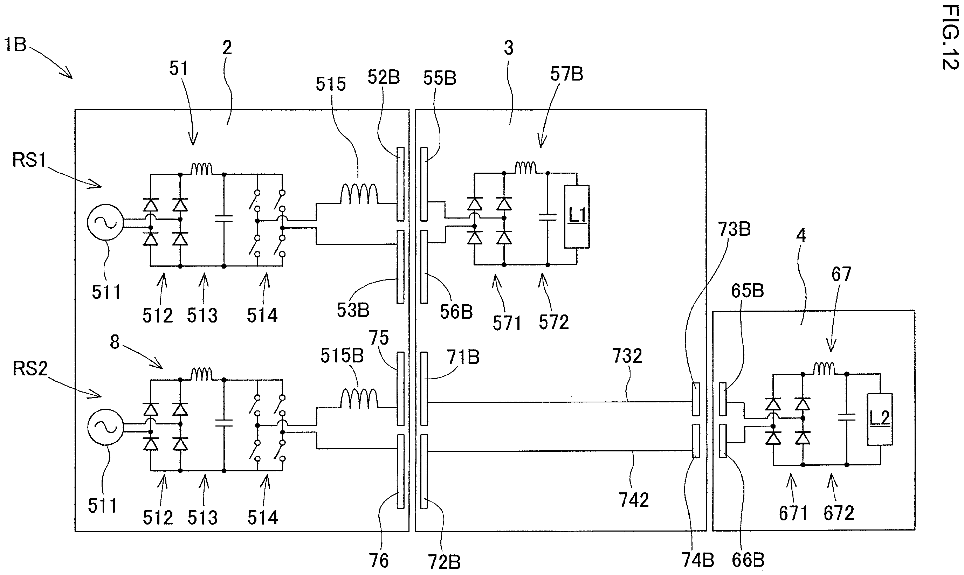

Next, a contactless power supply device 1B of a second embodiment will be described. Fig. 12 is an electric circuit diagram of the contactless power supply device 1B of the second embodiment. The contactless power supply device 1B of the second embodiment, similar to the first embodiment, can be equipped on the component mounting machine 10. As illustrated in Fig. 12, in the second embodiment, a first contactless power supply mechanism RS1 and a second contactless power supply mechanism RS2 are completely separated from each other and become independent. In the second embodiment, members having the same structures or the same functions as those of the first embodiment and related examople will be designated by the same reference numerals, and the description thereof will be omitted.

In the second embodiment, the first contactless power supply mechanism RS1 has a pair of first power supply electrode plates 52B and 53B provided at the static portion 2, and the high-frequency power source circuit 51 that supplies high-frequency electrical power to the first power supply electrode plates 52B and 53B. Additionally, the first contactless power supply mechanism RS1 has a pair of first power receiving electrode plates 55B and 56B that are provided at the Y-axis moving element 3, face the first power supply electrode plates 52B and 53B apart therefrom, and receive high-frequency electrical power in a contactless manner, and a first power receiving circuit 57B that converts the high-frequency electrical power received by the first power receiving electrode plates 55B and 56B and supplies the converted high-frequency c power to the first electrical load L1.

Meanwhile, the second contactless power supply mechanism RS2 has a pair of third power supply electrode plates 75 and 76 (third power supply element) provided at the static portion 2, and a second high-frequency power source circuit 8 that supplies high-frequency electrical power to the third power supply electrode plates 75 and 76. Additionally, the second contactless power supply mechanism RS2 has a pair of relay power receiving electrode plates 71B and 72B that are provided at the Y-axis moving element 3, face the third power supply electrode plates 75 and 76 apart therefrom, and receive high-frequency electrical power in a contactless manner, and a pair of relay power supply electrode plates 73B and 74B that are electrically connected to the relay power receiving electrode plates 71B and 72B with junction lines 732 and 742. Furthermore, the second contactless power supply mechanism RS2 has a pair of second power receiving elements 65B and 66B that are provided at the component mounting head 4, face the relay power supply electrode plates 73B and 74B apart therefrom, and receive high-frequency electrical power in a contactless manner, and the second power receiving circuit 67 that converts the high-frequency electrical power received by the second power receiving elements 65B and 66B and supplies the converted high-frequency power to the second electrical load L2.

Here, a total of four power supply electrode plates 52B, 53B, 75, and 76 are required for the static portion 2 side. Accordingly, the four electrode plates 52B, 53B, 75, and 76 are arranged apart from each other and parallel to each other on the upper surface of the bottom wall member 21 of the track member 151 so as to extend in the Y-axis direction. Otherwise, the pair of first power supply electrode plates 52B and 53B are arranged apart from each other and parallel to each other on the upper surface of the bottom wall member 21 so as to extend in the Y-axis direction, and the pair of third power supply electrode plates 75 and 76 are arranged on the surfaces of the magnets 24 of both of the side wall members 22 and 23. Naturally, the four power receiving electrode plates 55B, 56B, 71B, and 72B of the Y-axis moving element 3 are arranged in conformity with the arrangement of the four power supply electrode plates 52B, 53B, 75, and 76 on the static portion 2 side. Additionally, the second high-frequency power source circuit 8 can be adapted to have the same circuit configuration as the high-frequency power source circuit 51 of the first contactless power supply mechanism RS1, and the properties of the tuning coil 515B are changed if necessary.

In the second embodiment, a power supply route to the first electrical load L1 of the first contactless power supply mechanism RS1 is not different from that of the first embodiment and related example. Meanwhile, although the power supply route to the second electrical load L2 of the second contactless power supply mechanism RS2 goes via four capacitors constituted of a total of four sets of electrode plates (75 and 71B, 76 and 72B, 73B and 65B, and 74B and 66B), there is no change in that contactless power supply can be made through the electrostatic coupling method.

According to the contactless power supply device 1B of the second embodiment, contactless power supply can be performed from the static portion 2 to the second electrical load L2 of the component mounting head 4 which is driven by combining the linear motor device 150 and the ball screw feed mechanism. Accordingly, a cable that supplies electrical power from the static portion 2 to the component mounting head 4 is completely unnecessary, the load carrying weight of the cable becomes zero, the component mounting head 4 can be driven at higher speed than in the related art, and the risk of cable disconnection can be eliminated. Additionally, similar to the first embodiment, since separate output frequencies can be used for the high-frequency power source circuit 51 and the second high-frequency power source circuit 8, adjustment of the frequencies is relatively easy.

In addition, although the linear motor device 150 and the ball screw feed mechanism are illustrated as a plurality of drive mechanisms in the respective embodiments, combinations of the drive mechanisms can be freely selected. Additionally, the electric circuit configurations of the respective embodiments may be appropriately changed. For example, when the electrical loads L1 and L2 are a plurality of loads and are different from each other in terms of rated supply voltage, a multi-output voltage type power receiving circuit can be used. Additionally, for example, when the electrical loads L1 and L2 are AC loads, the power receiving circuit is constituted of an inverter device. In addition to this, the invention can be variously applied or modified.

### Industrial Applicability

The contactless power supply device of the invention can be used for substrate work apparatuses of a type in which a work head is moved in biaxial directions orthogonal to each other besides the component mounting machine.

### Reference Signs List

1, 1A, 1B: CONTACTLESS POWER SUPPLY DEVICE
2: STATIC PORTION 21: BOTTOM WALL MEMBER 22.23: SIDE WALL MEMBER 24: MAGNET
3: Y-AXIS MOVING ELEMENT (FIRST MOVABLE PORTION) 31: MOVABLE BODY PORTION
32: SLIDING MEMBER 33: ARMATURE 34, 35: X-AXIS RAIL
36: BALL SCREW 37: DRIVE MOTOR
4: COMPONENT MOUNTING HEAD (SECOND MOVABLE PORTION)
41: NUT DRIVE UNIT 42: SUCTION NOZZLE
51: HIGH-FREQUENCY POWER SOURCE CIRCUIT
52, 53: FIRST POWER SUPPLY ELECTRODE PLATE (FIRST POWER SUPPLY ELEMENT)
55, 55A, 55B, 56, 56A, 56B: FIRST POWER RECEIVING ELECTRODE PLATE (FIRST POWER RECEIVING ELEMENT)
57, 57A, 57B: FIRST POWER RECEIVING CIRCUIT
61: HIGH-FREQUENCY POWER TRANSMITTING CIRCUIT
62, 63: SECOND POWER SUPPLY ELECTRODE PLATE (SECOND POWER SUPPLY ELEMENT)
65, 65B, 66, 66B: SECOND POWER RECEIVING ELECTRODE PLATE (SECOND POWER RECEIVING ELEMENT)
67: SECOND POWER RECEIVING CIRCUIT
71, 72: RELAY POWER RECEIVING ELECTRODE PLATE (RELAY POWER RECEIVING ELEMENT)
73, 74: RELAY POWER SUPPLY ELECTRODE PLATE (RELAY POWER SUPPLY ELEMENT)
75, 76: THIRD POWER SUPPLY ELECTRODE PLATE (THIRD POWER SUPPLY ELEMENT)
8: SECOND HIGH-FREQUENCY POWER SOURCE CIRCUIT
10: COMPONENT MOUNTING MACHINE
110: SUBSTRATE CARRYING DEVICE 120: COMPONENT SUPPLY DEVICE
130, 140: COMPONENT TRANSFER DEVICE 150: LINEAR MOTOR DEVICE
180: DISPLAY SETTING DEVICE 190: MACHINE BASE
L1: FIRST ELECTRICAL LOAD L2: SECOND ELECTRICAL LOAD

## Claims

1. A contactless power supply device (1) comprising:
a static portion (2);
a first movable portion (3) that is movably mounted on the static portion (2);
a second movable portion (4) that is mounted so as to be movable relative to the first movable portion (3);
a first contactless power supply mechanism that supplies electrical power in a contactless manner from the static portion (2) to a first electrical load (L1) on the first movable portion (3); and
a second contactless power supply mechanism that supplies electrical power in a contactless manner from the static portion (2) via the first movable portion (3) to a second electrical load (L2) on the second movable portion (4),
wherein the first contactless power supply mechanism includes:
a first power supply element (52, 53) that is provided at the static portion (2), and a power source circuit (51) that supplies electrical power to the first power supply element (52,53) by means of a first high frequency generating circuit (514); and a first power receiving element (55, 56) that is provided at the first movable portion (3), faces the first power supply element (52, 53) apart therefrom, and receives high frequency electrical power in a contactless manner, and a first power receiving circuit (57) that converts the high frequency electrical power received by the first power receiving element (55, 56), and supplies the converted electrical power to the first electrical load (L1), and
wherein the second contactless power supply mechanism shares the first power supply element (52, 53), the high frequency power source circuit (51), the first power receiving element (55, 56), and the first power receiving circuit (57) of the first contactless power supply mechanism, and
includes a second power supply element (62, 63) that is provided at the first movable portion (3), and a high frequency power transmitting circuit (61) that has electrical power supplied from the first power receiving circuit (57) and that supplies high frequency electrical power to the second power supply element (62,63) by means of a second high frequency generating circuit (611); and
a second power receiving element (65, 66) that is provided at the second movable portion (4), faces the second power supply element (62, 63) apart therefrom, and receives electrical power in a contactless manner, and a second power receiving circuit (67) that converts the high frequency electrical power received by the second power receiving element (65, 66), and supplies the converted electrical power to the second electrical load (L2).

2. A contactless power supply device (1B) comprising:
a static portion (2);
a first movable portion (3) that is movably mounted on the static portion (2);
a second movable portion (4) that is mounted so as to be movable relative to the first movable portion (3);
a first contactless power supply mechanism that supplies electrical power in a contactless manner from the static portion (2) to a first electrical load (L1) on the first movable portion (3); and
a second contactless power supply mechanism that supplies electrical power in a contactless manner from the static portion (2) via the first movable portion (3) to a second electrical load (L2) on the second movable portion (4),
wherein the first contactless power supply mechanism includes:
a first power supply element (52B, 53B) that is provided at the static portion (2), and a first power source circuit (51) that supplies electrical power to the first power supply element (52B,53B) by means of a first high frequency generating circuit (514); and
a first power receiving element (55B, 56B) that is provided at the first movable portion (3), faces the first power supply element (52B, 53B) apart therefrom, and receives high frequency electrical power in a contactless manner, and a first power receiving circuit (57B) that converts the high frequency electrical power received by the first power receiving element (55B, 56B), and supplies the converted electrical power to the first electrical load (L1), and
wherein the second contactless power supply mechanism includes
a third power supply element (75, 76) that is provided at the static portion (2), and a second high frequency power source circuit (8) that supplies electrical power to the third power supply element (75,76) by means of a second high frequency generating circuit (514); a relay power receiving element (71B, 72B) that is provided at the first movable portion (3), faces the third power supply element (75, 76) apart therefrom, and receives high frequency electrical power in a contactless manner; and a relay power supply element (73B, 74B) that is electrically connected to the relay power receiving element (71B, 72B); and
a second power receiving element (65B, 66B) that is provided at the second movable portion (4), faces the relay power supply element (73B, 74B) apart therefrom, and receives high frequency electrical power in a contactless manner, and a second power receiving circuit (67) that converts the high frequency electrical power received by the second power receiving element (65B, 66B), and supplies the converted electrical power to the second electrical load (L2).

3. The contactless power supply device (1, 1B) according to Claim 1 or 2,
wherein at least one circuit among the power source circuit (51), the power transmitting circuit (61), and the second power source circuit (8) variably adjusts the frequency of the power to perform contactless power supply using a resonant circuit.

4. The contactless power supply device (1, 1B) according to any one of Claims 1 to 3,
wherein the first power supply element (52, 53; 52B, 53B), the first power receiving element (55, 56; 55B, 56B), the second power supply element (62, 63), the second power receiving element (65, 66), the relay power receiving element (71B, 72B), the relay power supply element (73B, 74B), and the third power supply element (75, 76) are electrode plates, respectively.

5. The contactless power supply device (1, 1B) according to any one clause of Claims 1 to 4,
wherein the first movable portion (3) is a Y-axis moving element that is equipped on a component mounting machine (10) that mounts components on a substrate, and is movable in a Y-axis direction perpendicular to an X-axis direction in which the substrate is carried in and carried out, and
wherein the second movable portion (4) is an X-axis moving element having a component mounting head (4) that performs a component mounting operation and being movable relative to the X-axis direction.

## Patentansprüche

1. Kontaktlose Stromversorgungsvorrichtung (1), die umfasst:
einen stationären Abschnitt (2);
einen ersten beweglichen Abschnitt (3), der beweglich an dem stationären Abschnitt (2) angebracht ist;
einen zweiten beweglichen Abschnitt (4), der so angebracht ist, dass er relativ zu dem ersten beweglichen Abschnitt (3) bewegt werden kann;
einen ersten kontaktlosen Stromversorgungs-Mechanismus, der einer ersten elektrischen Last (L1) an dem ersten beweglichen Abschnitt (3) Strom von dem stationären Abschnitt (2) kontaktlos zuführt; und
einen zweiten kontaktlosen Stromversorgungs-Mechanismus, der einer zweiten elektrischen Last (L2) an dem zweiten beweglichen Abschnitt (4) über den ersten beweglichen Abschnitt (3) Strom von dem stationären Abschnitt (2) kontaktlos zuführt,
wobei der erste kontaktlose Stromversorgungs-Mechanismus enthält:
ein erstes Stromversorgungs-Element (52, 53), das sich an dem stationären Abschnitt (2) befindet, und eine Stromquellen-Schaltung (51), die dem ersten Stromversorgungs-Element (52, 53) mittels einer ersten Hochfrequenzerzeugungs-Schaltung (514) Strom zuführt; sowie
ein erstes Stromempfangs-Element (55, 56), das sich an dem ersten beweglichen Abschnitt (3) befindet, dem ersten Stromversorgungs-Element (52, 53) von ihm getrennt zugewandt ist und Hochfrequenz-Strom kontaktlos empfängt, sowie eine erste Stromempfangs-Schaltung (57), die den über das erste Stromempfangs-Element (55, 56) empfangenen Hochfrequenz-Strom umwandelt und den umgewandelten Strom der ersten elektrischen Last (L1) zuführt, und
wobei der zweite kontaktlose Stromversorgungs-Mechanismus
das erste Stromversorgungs-Element (52, 53), die Hochfrequenz-Stromquellen-Schaltung (51), das erste Stromempfangs-Element (55, 56) sowie die erste Stromempfangs-Schaltung (57) des ersten kontaktlosen Stromversorgungs-Mechanismus anteilig nutzt, und
ein zweites Stromversorgungs-Element (62, 63), das sich an dem ersten beweglichen Abschnitt (3) befindet, und eine Hochfrequenz-Stromübertragungs-Schaltung (61), der Strom von der ersten Stromempfangs-Schaltung (57) zugeführt wird und die dem zweiten Stromversorgungs-Element (62, 63) mittels einer zweiten Hochfrequenzerzeugungs-Schaltung (611) Hochfrequenz-Strom zuführt; sowie
ein zweites Stromempfangs-Element (65, 66), das sich an dem zweiten beweglichen Abschnitt (4) befindet, dem zweiten Stromversorgungs-Element (62, 63) von ihm getrennt zugewandt ist und Strom kontaktlos empfängt, sowie eine zweite Stromempfangs-Schaltung (67) enthält, die den über das zweite Stromempfangs-Element (65, 66) empfangenen Hochfrequenz-Strom umwandelt und den umgewandelten Strom der zweiten elektrischen Last (L2) zuführt.

2. Kontaktlose Stromversorgungsvorrichtung (1B), die umfasst:
einen stationären Abschnitt (2);
einen ersten beweglichen Abschnitt (3), der beweglich an dem stationären Abschnitt (2) angebracht ist;
einen zweiten beweglichen Abschnitt (4), der so angebracht ist, dass er relativ zu dem ersten beweglichen Abschnitt (3) bewegt werden kann;
einen ersten kontaktlosen Stromversorgungs-Mechanismus, der einer ersten elektrischen Last (L1) an dem ersten beweglichen Abschnitt (3) Strom von dem stationären Abschnitt (2) kontaktlos zuführt; und
einen zweiten kontaktlosen Stromversorgungs-Mechanismus, der einer zweiten elektrischen Last (L2) an dem zweiten beweglichen Abschnitt (4) über den ersten beweglichen Abschnitt (3) Strom von dem stationären Abschnitt (2) kontaktlos zuführt,
wobei der erste kontaktlose Stromversorgungs-Mechanismus enthält:
ein erstes Stromversorgungs-Element (52B, 53B), das sich an dem stationären Abschnitt (2) befindet, und eine erste Stromquellen-Schaltung (51), die dem ersten Stromversorgungs-Element (52B, 53B) mittels einer ersten Hochfrequenzerzeugungs-Schaltung (514) Strom zuführt; sowie
ein erstes Stromempfangs-Element (55B, 56B), das sich an dem ersten beweglichen Abschnitt (3) befindet, dem ersten Stromversorgungs-Element (52B, 53B) von ihm getrennt zugewandt ist und Hochfrequenz-Strom kontaktlos empfängt, sowie eine erste Stromempfangs-Schaltung (57B), die den über das erste Stromempfangs-Element (55B, 56B) empfangenen Hochfrequenz-Strom umwandelt und den umgewandelten Strom der ersten elektrischen Last (L1) zuführt, und
wobei der zweite kontaktlose Stromversorgungs-Mechanismus enthält:
ein drittes Stromversorgungs-Element (75, 76), das sich an dem stationären Abschnitt (2) befindet, und eine zweite Hochfrequenz-Stromquellen-Schaltung (8), die dem dritten Stromversorgungs-Element (75, 76) mittels einer zweiten Hochfrequenzerzeugungs-Schaltung (611) Strom zuführt;
ein Zwischen-Stromempfangs-Element (71B, 72B), das sich an dem ersten beweglichen Abschnitt (3) befindet, dem dritten Stromversorgungs-Element (75, 76) von ihm getrennt zugewandt ist und Hochfrequenz-Strom kontaktlos empfängt, sowie ein Zwischen-Stromversorgungs-Element (73B, 74B), das elektrisch mit dem Zwischen-Stromempfangs-Element (71B, 72B) verbunden ist; und
ein zweites Stromempfangs-Element (65B, 66B), das sich an dem zweiten beweglichen Abschnitt (4) befindet, dem Zwischen-Stromversorgungs-Element (73B, 74B) von ihm getrennt zugewandt ist und Hochfrequenz-Strom kontaktlos empfängt, sowie eine zweite Stromempfangs-Schaltung (67), die den über das zweite Stromempfangs-Element (65B, 66B) empfangenen Hochfrequenz-Strom umwandelt und den umgewandelten Strom der zweiten elektrischen Last (L2) zuführt.

3. Kontaktlose Stromversorgungsvorrichtung (1, 1B) nach Anspruch 1 oder 2,
wobei wenigstens eine Schaltung von der Stromquellen-Schaltung (51), der Stromübertragungs-Schaltung (61) und der zweiten Stromquellen-Schaltung (8) die Frequenz des Stroms variabel reguliert, um kontaktlose Stromversorgung unter Verwendung eines Resonanzkreises durchzuführen.

4. Kontaktlose Stromversorgungsvorrichtung (1, 1B) nach einem der Ansprüche 1 bis 3,
wobei das erste Stromversorgungs-Element (52, 53; 52B, 53B), das erste Stromempfangs-Element (55, 56; 55B, 56B), das zweite Stromversorgungs-Element (62, 63), das zweite Stromempfangs-Element (65, 66), das Zwischen-Stromempfangs-Element (71B, 72B), das Zwischen-Stromversorgungs-Element (73B, 74B) und das dritte Stromversorgungs-Element (75, 76) jeweils Elektrodenplatten sind.

5. Kontaktlose Stromversorgungsvorrichtung (1, 1B) nach einer Klausel der Ansprüche 1 bis 4,
wobei der erste bewegliche Abschnitt (3) ein Y-Achsen-Bewegungselement ist, mit dem eine Bauteilbestückungs-Maschine (10) ausgestattet ist, die ein Substrat mit Bauteilen bestückt, und in einer Y-Achsen-Richtung senkrecht zu einer X-Achsen-Richtung bewegt werden kann, in der das Substrat zugeführt und abgeführt wird, und
der zweite bewegliche Abschnitt (4) ein X-Achsen-Bewegungselement ist, das einen Bauteilbestückungs-Kopf (4) aufweist, der einen Bauteilbestückungs-Vorgang durchführt und relativ zu der X-Achsen-Richtung bewegt werden kann.

## Revendications

1. Dispositif d'alimentation sans contact (1), comprenant :
une partie statique (2) ;
une première partie mobile (3) qui est montée de manière mobile sur la partie statique (2) ;
une seconde partie mobile (4) qui est montée de manière à pouvoir se déplacer par rapport à la première partie mobile (3) ;
un premier mécanisme d'alimentation sans contact qui fournit, sans contact, de l'énergie électrique de la partie statique (2) à une première charge électrique (L1) sur la première partie mobile (3) ; et
un second mécanisme d'alimentation sans contact qui fournit, sans contact, de l'énergie électrique de la partie statique (2) à une seconde charge électrique (L2) sur la seconde partie mobile (4) par l'intermédiaire de la première partie mobile (3),
dans lequel le premier mécanisme d'alimentation sans contact inclut :
un premier élément d'alimentation (52, 53) qui est situé au niveau de la partie statique (2) et un circuit source d'énergie (51) qui fournit de l'énergie électrique au premier élément d'alimentation (52, 53) au moyen d'un premier circuit générateur de haute fréquence (514) ; et
un premier élément récepteur d'énergie (55, 56) qui est situé au niveau de la première partie mobile (3), en face du premier élément d'alimentation (52, 53) et à une distance de celui-ci, et reçoit, sans contact, de l'énergie électrique haute fréquence, et un premier circuit récepteur d'énergie (57) qui convertit l'énergie électrique haute fréquence reçue par le premier élément récepteur d'énergie (55, 56) et fournit l'énergie électrique convertie à la première charge électrique (L1), et
dans lequel le second mécanisme d'alimentation sans contact partage avec le premier mécanisme d'alimentation sans contact le premier élément d'alimentation (52, 53), le circuit source d'énergie haute fréquence (51), le premier élément récepteur d'énergie (55, 56) et le premier circuit récepteur d'énergie (57), et
inclut un deuxième élément d'alimentation (62, 63) qui est situé au niveau de la première partie mobile (3) et un circuit émetteur d'énergie haute fréquence (61) qui est alimenté en énergie électrique par le premier circuit récepteur d'énergie (57) et qui fournit de l'énergie électrique haute fréquence au deuxième élément d'alimentation (62, 63) au moyen d'un second circuit générateur de haute fréquence (611) ; et
un second élément récepteur d'énergie (65, 66) qui est situé au niveau de la seconde partie mobile (4), en face du deuxième élément d'alimentation (62, 63) et à une distance de celui-ci, et reçoit, sans contact, de l'énergie électrique, et un second circuit récepteur d'énergie (67) qui convertit l'énergie électrique haute fréquence reçue par le second élément récepteur d'énergie (65, 66) et fournit l'énergie électrique convertie à la seconde charge électrique (L2).

2. Dispositif d'alimentation sans contact (1B), comprenant :
une partie statique (2) ;
une première partie mobile (3) qui est montée de manière mobile sur la partie statique (2) ;
une seconde partie mobile (4) qui est montée de manière à pouvoir se déplacer par rapport à la première partie mobile (3) ;
un premier mécanisme d'alimentation sans contact qui fournit, sans contact, de l'énergie électrique de la partie statique (2) à une première charge électrique (L1) sur la première partie mobile (3) ; et
un second mécanisme d'alimentation sans contact qui fournit, sans contact, de l'énergie électrique de la partie statique (2) à une seconde charge électrique (L2) sur la seconde partie mobile (4) par l'intermédiaire de la première partie mobile (3),
dans lequel le premier mécanisme d'alimentation sans contact inclut :
un premier élément d'alimentation (52B, 53B) qui est situé au niveau de la partie statique (2) et un premier circuit source d'énergie (51) qui fournit de l'énergie électrique au premier élément d'alimentation (52B, 53B) au moyen d'un premier circuit générateur de haute fréquence (514) ; et
un premier élément récepteur d'énergie (55B, 56B) qui est situé au niveau de la première partie mobile (3), en face du premier élément d'alimentation (52B, 53B) et à une distance de celui-ci, et reçoit, sans contact, de l'énergie électrique haute fréquence, et un premier circuit récepteur d'énergie (57B) qui convertit l'énergie électrique haute fréquence reçue par le premier élément récepteur d'énergie (55B, 56B) et fournit l'énergie électrique convertie à la première charge électrique (L1), et
dans lequel le second mécanisme d'alimentation sans contact inclut
un troisième élément d'alimentation (75, 76) qui est situé au niveau de la partie statique (2) et un second circuit source d'énergie haute fréquence (8) qui fournit de l'énergie électrique au troisième élément d'alimentation (75, 76) au moyen d'un second circuit générateur de haute fréquence (514) ;
un élément récepteur d'énergie formant relais (71B, 72B) qui est situé au niveau de la première partie mobile (3), en face du troisième élément d'alimentation (75, 76) et à une distance de celui-ci, et reçoit, sans contact, de l'énergie électrique haute fréquence ; et un élément d'alimentation formant relais (73B, 74B) qui est connecté électriquement à l'élément récepteur d'énergie formant relais (71B, 72B) ; et
un second élément récepteur d'énergie (65B, 66B) qui est situé au niveau de la seconde partie mobile (4), en face de l'élément d'alimentation formant relais (73B, 74B) et à une distance de celui-ci, et reçoit, sans contact, de l'énergie électrique haute fréquence, et un second circuit récepteur d'énergie (67) qui convertit l'énergie électrique haute fréquence reçue par le second élément récepteur d'énergie (65B, 66B) et fournit l'énergie électrique convertie à la seconde charge électrique (L2).

3. Dispositif d'alimentation sans contact (1, 1B) selon la revendication 1 ou 2,
dans lequel au moins circuit, entre le circuit source d'énergie (51), le circuit émetteur d'énergie (61) et le second circuit source d'énergie (8), règle de manière variable la fréquence de l'énergie pour obtenir une alimentation sans contact à l'aide d'un circuit résonnant.

4. Dispositif d'alimentation sans contact (1, 1B) selon l'une quelconque des revendications 1 à 3,
dans lequel le premier élément d'alimentation (52, 53; 52B, 53B), le premier élément récepteur d'énergie (55, 56; 55B, 56B), le deuxième élément d'alimentation (62, 63), le second élément récepteur d'énergie (65, 66), l'élément récepteur d'énergie formant relais (71B, 72B), l'élément d'alimentation formant relais (73B, 74B) et le troisième élément d'alimentation (75, 76) sont, respectivement, des électrodes planes.

5. Dispositif d'alimentation sans contact (1, 1B) selon l'une quelconque des revendications 1 à 4,
dans lequel la première partie mobile (3) est un élément mobile le long d'un axe Y, qui équipe une machine de montage de composants (10) qui monte des composants sur un substrat et qui peut se déplacer dans la direction d'un axe Y perpendiculaire à la direction d'un axe X dans laquelle le substrat est amené et enlevé, et
dans lequel la seconde partie mobile (4) est un élément mobile le long d'un axe X comportant une tête de montage de composant (4) qui exécute une opération de montage de composant, et mobile par rapport à la direction de l'axe X.
